(19) Europäisches Patentamt
European Patent Office
Office européen des brevets

(11) **EP 3 906 460 B1**

(12) **FASCICULE DE BREVET EUROPEEN**

(45) Date de publication et mention
de la délivrance du brevet:
**05.02.2025   Bulletin 2025/06**

(21) Numéro de dépôt: **19845698.0**

(22) Date de dépôt: **30.12.2019**

(51) Classification Internationale des Brevets (IPC):
***G06F 3/01*** *(2006.01)*

(52) Classification Coopérative des Brevets (CPC):
**G06F 3/016**

(86) Numéro de dépôt international:
**PCT/FR2019/000222**

(87) Numéro de publication internationale:
**WO 2020/141263 (09.07.2020 Gazette 2020/28)**

(54) **PROCÉDÉ DE CRÉATION D'UN EFFET HAPTIQUE AU MOYEN D'ONDES ULTRASONORES FOCALISÉES**

VERFAHREN ZUR ERZEUGUNG EINES HAPTISCHEN EFFEKTS MITTELS FOKUSSIERTER ULTRASCHALLWELLEN

METHOD FOR CREATING A HAPTIC EFFECT BY MEANS OF FOCUSED ULTRASOUND WAVES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **31.12.2018   FR 1874414**

(43) Date de publication de la demande:
**10.11.2021   Bulletin 2021/45**

(73) Titulaire: **Hap2u**
**38400 Saint-Martin-d'Hères (FR)**

(72) Inventeur: **RUPIN, Matthieu**
**38400 Saint Martin d'Hères (FR)**

(74) Mandataire: **Tranvouez, Edern Morgan**
**Brandon IP**
**64 rue Tiquetonne**
**75002 Paris (FR)**

(56) Documents cités:
**WO-A1-2008/116980      WO-A1-2008/116980**
**WO-A1-2018/197794      US-A1- 2016 132 117**
**US-B1- 8 593 409**

**Description**

L'invention concerne le domaine des surfaces capables de générer un effet de retour haptique, en particulier par lubrification ultrasonique lorsqu'elles sont touchées par le doigt d'un utilisateur.

## ETAT DE LA TECHNIQUE

On sait que la lubrification ultrasonique d'une surface peut être utilisée pour créer un effet haptique sous la forme d'une sensation de texture sous le doigt d'un utilisateur, encore appelée « effet squeeze film », via la modification du coefficient de frottement de la surface. Cet effet est obtenu par la mise en vibration de la surface par l'application d'une onde stationnaire ultrasonique, comme cela est déjà connu de par le document WO2008116980 A1.

Cet effet nécessite des déplacements ultrasoniques de forte amplitude de la surface, qui sont obtenus aujourd'hui grâce à l'utilisation d'une résonance d'ensemble de la surface (plaque mince élastique). Cette résonance joue le rôle d'amplificateur passif et donne de bons résultats lorsque la surface est essentiellement élastique et absorbe très peu l'énergie de la vibration ultrasonique qui lui est appliquée, comme par exemple une surface en verre.

En revanche lorsque le milieu utilisé pour obtenir un retour haptique est trop massif, ou fortement dissipatif pour les ondes de surface élastiques dans le domaine des fréquence ultrasoniques, ou lorsque le point à actionner sur la surface est distant des actionneurs, il est aujourd'hui difficile d'obtenir un retour haptique de qualité, c'est-à-dire avec de fortes amplitudes de déplacement de la surface qui soient bien perceptibles par l'utilisateur, et avec un rendement énergétique acceptable. En outre, dans les milieux dissipatifs, l'actionneur piézoélectrique générant la vibration ultrasonique doit être localisé à proximité immédiate du point de la surface où l'effet doit être généré, ce qui exclut l'application à des surfaces transparentes, en l'absence d'actionneurs piézoélectriques eux-mêmes transparents.

On connaît par ailleurs par le document US 8 593 409 B1 un dispositif pour générer un retour haptique sur une surface à l'aide d'une pluralité d'actionneurs dont certains sont utilisés pour générer un retour haptique de type vibrotactile d'au moins 200 micromètres d'amplitude et de basse fréquence à un point donné, et dont d'autres sont utilisés pour minimiser le retour haptique à un autre point de la surface.

Le document US 2016/132117 A1 propose un dispositif électronique présentant suite à un toucher d'une surface par un utilisateur, un retour haptique d'amplitude de l'ordre de 30 micromètres dans une bande de fréquence allant jusqu'à 500 Hz.

Le document WO 2018/197794 A1 décrit une interface à retour haptique utilisant un effet de lubrification ultrasonique généré par des actionneurs piézoélectriques et visant à faire en sorte que les contributions des différents actionneurs s'additionnent en un point cible. Cependant, dans ce document, les signaux produits par les actionneurs ne sont pas « calculés » mais « acquis », c'est-à-dire mesurés dans une phase antérieure de calibration. Dans cette phase, une base de données dite « base de données de réponses impulsionnelles retournées » est constituée par des mesures en plusieurs zones de contact avec la surface. Ces données sont ensuite utilisées lors d'un contact de l'utilisateur dans une zone de l'interface.

## BUT DE L'INVENTION

L'invention a pour but général d'étendre le domaine d'application du retour haptique par lubrification ultrasonique à une plus grande variété de supports, par exemple les supports relativement dissipatifs comme par exemple le bois ou les matières plastiques, ou plus généralement les milieux dits viscoélastiques, ou encore les milieux élastiques mais plus épais que ceux pour lesquels l'effet de lubrification ultrasonique est déjà utilisé.

L'invention a également pour but de permettre d'obtenir un retour haptique bien perceptible à des points d'une surface distants de la localisation des actionneurs, comme cela peut être utile par exemple pour les surfaces de verre dans le domaine du bâtiment.

L'invention a encore pour but de permettre l'obtention d'un retour haptique multipoints, c'est-à-dire des retours haptiques différenciés mais simultanés en différents points d'un solide.

## PRINCIPE DE L'INVENTION

La présente invention décrit une méthode pour obtenir ce phénomène de lubrification ultrasonique localisée sous le doigt de l'utilisateur par le biais d'ultrasons focalisés.

Dans son principe, l'invention consiste à utiliser le principe de focalisation d'ondes, en particulier d'ondes élastiques de surface dans la gamme des fréquences ultrasoniques pour obtenir de fortes amplitudes de déplacements à un point de focalisation dans des milieux dissipatifs ou trop massifs ou trop distants des actionneurs pour être facilement actionnés. La commande des actionneurs est pour cela optimisée pour créer une sensation de texture sous le doigt de l'utilisateur via la modification du coefficient de frottement au niveau du point de focalisation.

**OBJET DE L'INVENTION**

L'invention est définie dans les revendications indépendantes 1 et 2. Un aspect de l'invention concerne un procédé pour générer un effet haptique en un point cible (R) d'un solide à l'aide d'au moins deux actionneurs piézoélectriques ($S_i$) aptes à émettre, à un instant donné t, une onde sous l'effet de signaux de commande d'une fréquence ultrasonique aptes à créer des vibrations à la surface du solide de façon à créer un effet dit de « lubrification ultrasonique » (ou effet dit de « squeeze-film » en terminologie anglo-saxonne) au point cible (R), caractérisé en ce que le signal de commande respectif de chaque actionneur ($S_i$) est calculé en fonction de la vitesse des ondes et la distance ($d_i$) entre cet actionneur et le point cible (R) à actionner, de manière que les déformations de la surface obtenues au point cible considéré s'additionnent pour y créer un effet haptique supérieur à celui obtenu à l'aide d'un actionneur unique.

Selon un mode de réalisation, les vibrations générées par les actionneurs piézoélectriques ($S_i$) à la surface du solide correspondent à des ondes de flexion.

Un autre aspect de l'invention concerne un dispositif de génération d'un effet haptique en un point cible (R) d'un solide, caractérisé en ce qu'il comporte au moins deux actionneurs ($S_1$, $S_2$) aptes à émettre à un instant donné ($t_1$, $t_2$) une onde de surface sous l'effet d'un signal de commande de chaque actionneur, et des moyens de commande configurés de manière que le signal de commande respectif émis à destination de chaque actionneur est calculé en fonction de la vitesse des ondes et de la distance entre cet actionneur et le point cible (R) à actionner, de manière que les déformations de la surface obtenues au point cible considéré s'additionnent pour y créer un effet haptique supérieur à celui obtenu à l'aide d'un actionneur unique.

Selon un mode de réalisation, le solide est un solide viscoélastique, par exemple comme le bois, ou une matière plastique.

De préférence, ledit solide présente une propagation d'onde isotrope, de manière à simplifier le calcul des temps de retard entre les signaux de commande pour obtenir une bonne focalisation à un point cible visé.

Selon un mode de réalisation, le solide est une surface transparente à la lumière et une pluralité d'actionneurs sont positionnés en bordure de ladite surface.

Selon un autre mode de réalisation, le solide est une surface opaque à la lumière, et une pluralité d'actionneurs sont positionnés en divers points sur la surface, par exemple dans une zone où les actionneurs ne seront pas visibles.

Selon un mode de réalisation avantageux, les actionneurs sont des actionneurs piézoélectriques.

**DESCRIPTION DETAILLEE**

L'invention sera décrite plus en détail à l'aide des figures dans lesquelles :

- La figure 1 illustre le principe de la focalisation d'ondes élastiques de surface sur un solide à partir de deux actionneurs ;

- La figure 2 est une vue schématique d'un ensemble d'actionneurs ultrasoniques disposés sur une ligne droite et pilotés pour créer une onde élastique de surface focalisée en un point d'un solide ;

- La figure 3 illustre une utilisation possible du procédé selon l'invention pour actionner un point d'une surface transparente.

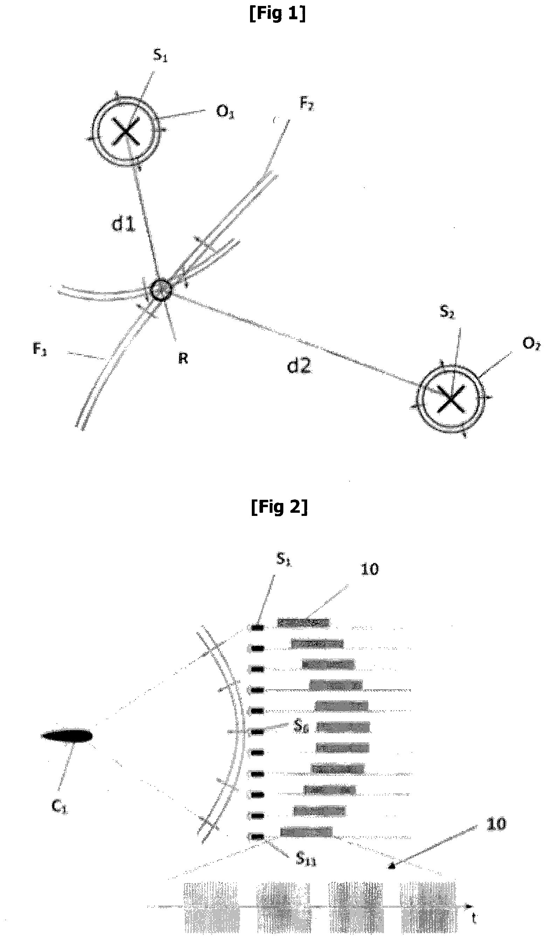

En figure 1 on a illustré le principe de sommation en un point à actionner des ondes élastiques $O_1$, $O_2$ émises par deux sources ponctuelles $S_1$, $S_2$ respectivement distantes d'une distance $d_1$, $d_2$. Les sources $S_1$, $S_2$ émettent chacune une onde, par exemple une onde ultrasonore crée par des actionneurs piézoélectriques (non représentés). Les fronts d'ondes $F_1$, $F_2$ des ondes $O_1$, $O_2$ se croisent au point R et y créent une déformation perpendiculaire au plan de la surface contenant les sources $S_1$, $S_2$, dans le cas d'une onde de surface de flexion (type onde de Lamb A0 dans le cas particulier d'une plaque mince), et un déplacement ultrasonique noté w dans le cas général.

Le déplacement hors-plan w obtenu au point $\vec{r}$ par deux sources situées aux points $\vec{s}_i$ avec i=1,2, s'exprime par la relation suivante :

$$w(\vec{r}, t_0) = \sum_{i=1}^{2} \int_{tj}^{t0} G(r, \vec{s}i \, ; t, ti) f(\vec{s}i, ti) dt \qquad (1)$$

où $f(\vec{s}, t)$ représente les fonctions sources, émises aux points $s_i$ et au temps initiaux $t_i$ et $G(\vec{r}, \vec{s}_i \, ; t, t_i)$ sont les fonctions de Green entre les points sources et le point de focalisation $\vec{r}$. Le temps $t = t_0$ correspond au temps où les ondes issues des deux sources $S_1$, $S_2$ se somment constructivement au point $\vec{r}$. Les temps d'émission $t_i$ sont définis à partir de la connaissance de la vitesse des ondes de flexion dans le milieu par la relation suivante :

$$t_i = t_0 - d_i / c(\omega) \qquad\qquad (2)$$

L'équation 1 représente donc un ensemble de produits de convolution entre deux sources et un point de réception situé en $\vec{r}$.

Dans le cas où les signaux à générer sont constitués d'une seule fréquence (on parle de signaux monochromatiques), l'équation (1) reste vraie et les retards temporels $t_i$ de l'équation (2) correspondent à des déphasages. En effet, pour des signaux monochromatiques, la vibration peut s'écrire dans le domaine de Fourier sous la forme d'un nombre complexe dont la valeur absolue correspond à l'amplitude de l'oscillation et l'argument traduit la distribution spatiale et temporelle de la vibration. Aussi, lors de l'émission par plusieurs point-sources d'un signal monochromatique il importe que l'argument de ces différentes contributions prenne la même valeur au point-cible (R) (cas des vibrations en phase). Aussi, soit $\varphi(R, S_i)$ l'argument des vibrations perçues au point-cible (R) suite à l'émission depuis le point-source $S_i$, on a, dans l'approximation des ondes planes et en omettant le terme lié à l'oscillation temporelle :

$$\varphi(R, S_i) \;=\; e^{-ik|\overrightarrow{rs_i}|}$$

Avec :

- $|\overrightarrow{rs_i}|$ la distance entre le point-cible (R) et le point-source $S_i$,

- $k$ le nombre d'onde.

Afin d'obtenir des signaux issus de différents point-sources qui soient en phase au point-cible (R), il convient d'ajouter un déphasage aux point-sources additionnels qui s'exprime ainsi :

$$k\Delta d$$

avec $\Delta d$ l'écart de distance entre le point-source pris comme référence (arbitraire) et le(s) point-source(s) additionnel(s). A titre d'illustration, dans le cas particulier de deux point-sources $S_1$ et $S_2$ et en prenant en référence le point $S_1$, la vibration perçue au point-cible (R) est constituée de la somme des contributions de S1 et S2 :

$$\varphi(R, S_i) \;=\; e^{-ik|\overrightarrow{rs_1}|} + e^{-ik(|\overrightarrow{rs_2}|+\Delta d)}$$

Ce principe de focalisation peut être adapté à la focalisation des ondes ultrasoniques de surface issues d'un plus grand nombre de sources.

En effet, le déplacement hors plan obtenu en un point d'une surface peut être insuffisant pour être perceptible par un doigt lorsqu'il n'est produit que par la sommation de deux ondes générées par deux actionneurs, ou lorsque le point à actionner est trop distant de la localisation des actionneurs et que le milieu de propagation est viscoélastique. Dans ces cas, il est utile d'utiliser un plus grand nombre d'actionneurs disposés à un endroit non gênant de la surface à actionner, mais il est alors nécessaire que les vibrations ultrasoniques soient pilotées pour qu'un retour haptique puisse être généré de façon cohérente au point visé.

Un exemple de réalisation utilisant des sources multiples est représenté en figure 2. Dans cette figure, on a représenté une zone C1 de petite taille d'un solide isotrope, qui doit être actionnée par une pluralité d'actionneurs, notamment 11 actionneurs piézoélectriques repérés par $S_1$ à $S_{11}$. Les différents actionneurs $S_i$ sont actionnés par des signaux de commande délivrant des ondes vibratoires 10 comme schématisé dans le graphe agrandi au bas de la figure 2. Selon l'invention, les trains d'onde sont décalés dans le temps de manière à se sommer de façon constructive au point cible C1. Par exemple, le signal de commande appliqué à l'actionneur $S_6$ qui est le plus proche de la zone cible C1, est retardé par rapport au signal de commande des actionneurs voisins. Le retard est calculé de manière que le déplacement dû à la sommation au point cible C1 des ondes issues de tous les actionneurs soit maximal.

Bien entendu, si plusieurs points cibles sont à viser, il suffira de recalculer les temps de retard des signaux de commande des différents actionneurs pour que la focalisation des ondes ultrasoniques soit maximale à tel ou tel point considéré.

Cette façon de procéder permet d'envisager de créer des effets haptiques bien perceptibles dans un grand nombre de situations applicatives nouvelles.

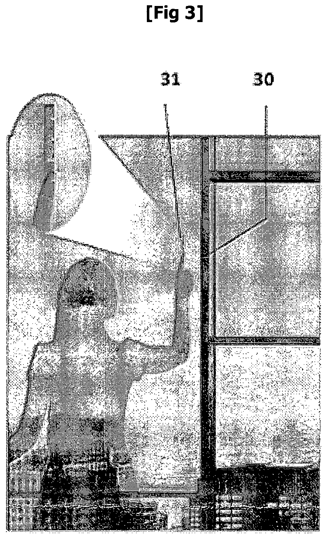

Un exemple applicatif nullement limitatif est schématisé en figure 3. Un ensemble d'actionneurs (non représentés) est placé en ligne dans une zone 30 en bordure d'un vitrage de bâtiment. Un effet haptique par lubrification ultrasonique est souhaité au point 31 du vitrage, distant de la zone 30. Compte tenu de la distance entre la bordure du vitrage et le point 31 cible, les technologies selon l'état de la technique ne permettent pas de générer un effet haptique perceptible au point cible 31, à moins de placer un gros actionneur visible directement au voisinage du point cible. L'invention permet au contraire de déporter une série d'actionneurs dans une zone distante non gênante sur le plan visuel, et d'obtenir un actionnement bien perceptible au point cible 31. En outre, plusieurs points cibles peuvent être visés, il suffit de calculer les lois de retard des signaux de commande de manière à maximiser le déplacement de la surface de verre à n'importe quel point visé.

## AVANTAGES DE L'INVENTION

L'invention permet d'atteindre les buts fixés. En particulier, le procédé selon l'invention permet de générer un effet haptique de type lubrification ultrasonique à des points d'une surface distants de la position des actionneurs piézoélectriques, ou à des points d'une surface dont le matériau est de type viscoélastique. En cela, l'invention permet d'étendre considérablement le champ d'application des technologies de retour haptique par effet de lubrification ultrasonique, comme par exemple le secteur des vitrages de bâtiment intelligents ou des vitrages automobiles, mais aussi d'autres secteurs applicatifs comme le secteur de l'ameublement utilisant des matériaux comme le bois ou les matières plastiques.

## Revendications

1.    Procédé pour générer un effet haptique de lubrification ultrasonique en un point cible (R) d'une surface rigide d'un solide à l'aide d'au moins deux actionneurs piézoélectriques ($S_i$) aptes à générer sous l'effet de signaux de commande une vibration dans le domaine ultrasonique de ladite surface rigide pour créer un effet dit de lubrification ultrasonique en un point cible (R), **caractérisé en ce que** le signal de commande respectif de chaque actionneur ($S_i$) est calculé sur la base d'une loi de retard qui est fonction de la vitesse de propagation des ondes émises des actionneurs dans le solide et de la distance ($d_i$) entre cet actionneur et le point cible (R) à actionner, la loi de retard servant à déterminer les signaux de commande de manière que l'amplitude du déplacement au point cible (R) des ondes issues de tous les actionneurs piézoélectriques ($S_i$) soit maximale pour créer au point cible (R) un effet haptique de lubrification ultrasonique supérieur à celui obtenu à l'aide d'un actionneur unique.

2.    Dispositif de génération d'un effet haptique de lubrification ultrasonique en un point cible (R) d'une surface rigide d'un solide selon un procédé conforme à la revendication 1, **caractérisé en ce qu'**il comporte au moins deux actionneurs ($S_1$, $S_2$) aptes à émettre à un instant donné t une onde de surface de fréquence ultrasonique sous l'effet d'un signal de commande de chaque actionneur ($S_i$) , et des moyens de commande des actionneurs configurés de manière que le signal de commande respectif émis à destination de chaque actionneur soit calculé sur la base d'une loi de retard qui est fonction de la vitesse de propagation des ondes émises des actionneurs dans le solide et de la distance ($d_i$) entre cet actionneur et le point cible (R) à actionner, de manière que le déplacement au point cible (R) des ondes issues de tous les actionneurs piézoélectriques ($S_i$) soit maximal pour créer au point cible (R) un effet haptique de lubrification ultrasonique supérieur à celui obtenu à l'aide d'un actionneur unique.

3.    Dispositif selon la revendication 2, **caractérisé en ce que** le solide est un solide viscoélastique.

4.    Dispositif selon la revendication 2 ou la revendication 3, **caractérisé en ce que** ledit solide présente une propagation d'onde isotrope.

5.    Dispositif selon la revendication 4, **caractérisé en ce que** le solide est une surface transparente à la lumière et **en ce qu'**une pluralité d'actionneurs sont positionnés en bordure de ladite surface.

6.    Dispositif selon la revendication 4, **caractérisé en ce que** le solide est une surface opaque à la lumière, et **en ce qu'**une pluralité d'actionneurs sont positionnés en divers points sur la surface.

7.    Dispositif selon l'une quelconque des revendications 4 à 6, **caractérisé en ce que** lesdits actionneurs sont des actionneurs piézoélectriques.

8.    Dispositif selon l'une quelconque des revendications 4 à 7, **caractérisé en ce que** lesdits actionneurs sont des actionneurs amplifiés.

**EP 3 906 460 B1**

**Patentansprüche**

1. Verfahren zum Erzeugen eines haptischen Ultraschall-Schmiereffekts an einem Zielpunkt (R) einer starren Oberfläche eines Feststoffs mithilfe von mindestens zwei piezoelektrischen Stellantrieben ($S_i$), die imstande sind, unter dem Effekt von Steuersignalen eine Schwingung im Ultraschallbereich der starren Oberfläche zu erzeugen, um einen sogenannten Ultraschall-Schmiereffekt an einem Zielpunkt (R) zu schaffen, **dadurch gekennzeichnet, dass** das jeweilige Steuersignal eines jeden Stellantriebs ($S_i$) auf der Basis eines Verzögerungsgesetzes berechnet wird, das von der Ausbreitungsgeschwindigkeit der von den Stellantrieben ausgesandten Wellen in dem Feststoff und dem Abstand ($d_i$) zwischen diesem Stellantrieb und dem zu betätigenden Zielpunkt (R) abhängig ist, wobei das Verzögerungsgesetz dazu dient, die Steuersignale so zu bestimmen, dass die Amplitude der Verschiebung am Zielpunkt (R) der aus allen piezoelektrischen Stellantrieben ($S_i$) stammenden Wellen maximal ist, um am Zielpunkt (R) einen haptischen Ultraschall-Schmiereffekt zu schaffen, der größer als jener ist, der mithilfe eines einzigen Stellantriebs erhalten wird.

2. Vorrichtung zum Erzeugen eines haptischen Ultraschall-Schmiereffekts an einem Zielpunkt (R) einer starren Oberfläche eines Feststoffs gemäß einem Verfahren nach Anspruch 1, **dadurch gekennzeichnet, dass** sie mindestens zwei Stellantriebe ($S_1$, $S_2$) beinhaltet, die imstande sind, zu einem gegebenen Zeitpunkt t eine Oberflächenwelle mit Ultraschallfrequenz unter dem Effekt eines Steuersignals eines jeden Stellantriebs ($S_i$) auszugeben, und Steuermittel der Stellantriebe, die konfiguriert sind, sodass das jeweilige in Richtung eines jeden Stellantriebs ausgegebene Steuersignal auf der Basis eines Verzögerungsgesetzes berechnet wird, das von der Ausbreitungsgeschwindigkeit der von den Stellantrieben ausgesandten Wellen in dem Feststoff und dem Abstand ($d_i$) zwischen diesem Stellantrieb und dem zu betätigenden Zielpunkt (R) abhängig ist, sodass die Verschiebung zum Zielpunkt (R) der aus allen piezoelektrischen Stellantrieben ($S_i$) stammenden Wellen maximal ist, um am Zielpunkt (R) einen haptischen Ultraschall-Schmiereffekt zu schaffen, der größer als jener ist, der mithilfe eines einzigen Stellantriebs erhalten wird.

3. Vorrichtung nach Anspruch 2, **dadurch gekennzeichnet, dass** der Feststoff ein viskoelastischer Feststoff ist.

4. Vorrichtung nach Anspruch 2 oder Anspruch 3, **dadurch gekennzeichnet, dass** der Feststoff eine isotrope Wellenausbreitung aufweist.

5. Vorrichtung nach Anspruch 4, **dadurch gekennzeichnet, dass** der Feststoff eine für das Licht transparente Oberfläche ist, und dadurch, dass eine Vielzahl von Stellantrieben am Rand der Oberfläche positioniert sind.

6. Vorrichtung nach Anspruch 4, **dadurch gekennzeichnet, dass** der Feststoff eine für das Licht opake Oberfläche ist, und dadurch, dass eine Vielzahl von Stellantrieben an verschiedenen Punkten auf der Oberfläche positioniert sind.

7. Vorrichtung nach einem der Ansprüche 4 bis 6, **dadurch gekennzeichnet, dass** die Stellantriebe piezoelektrische Stellantriebe sind.

8. Vorrichtung nach einem der Ansprüche 4 bis 7, **dadurch gekennzeichnet, dass** die Stellantriebe verstärkte Stellantriebe sind.

**Claims**

1. A method for generating an ultrasonic lubrication haptic effect at a target point (R) of a rigid surface of a solid using at least two piezoelectric actuators ($S_i$) capable of generating, under the effect of control signals, a vibration of said rigid surface in the ultrasonic domain so as to create a so-called ultrasonic lubrication effect at a target point (R), **characterised in that** the respective control signal of each actuator ($S_i$) is calculated on the basis of a delay law which depends on the speed of propagation of the emitted waves of the actuators in the solid and on the distance ($d_i$) between this actuator and the target point (R) to be actuated, the delay law being used to determine the control signals so that the amplitude of the displacement at the target point (R) of the waves originating from all of the piezoelectric actuators ($S_i$) is maximum to create, at the target point (R), an ultrasonic lubrication haptic effect higher than that one obtained using one single actuator.

2. A device for generating an ultrasonic lubrication haptic effect at a target point (R) of a rigid surface of a solid according to a method in accordance with claim 1, **characterised in that** it includes at least two actuators ($S_1$, $S_2$) capable of emitting, at a given time point t, an ultrasonic frequency surface wave under the effect of a control signal of each

actuator ($S_i$), and means for controlling the actuators configured so that the respective control signal emitted to each actuator is calculated on the basis of a delay law which depends on the speed of propagation of the emitted waves of the actuators in the solid and on the distance ($d_i$) between this actuator and the target point (R) to be actuated, so that the displacement at the target point (R) of the waves originating from all of the piezoelectric actuators ($S_i$) is maximum to create, at the target point (R), an ultrasonic lubrication haptic effect higher than that one obtained using one single actuator.

3. The device according to claim 2, **characterised in that** the solid is a viscoelastic solid.

4. The device according to claim 2 or claim 3, **characterised in that** said solid features an isotropic wave propagation.

5. The device according to claim 4, **characterised in that** the solid is a surface that is transparent to light, and **in that** a plurality of actuators are positioned at the boundary of said surface.

6. The device according to claim 4, **characterised in that** the solid is a surface that is opaque to light, and **in that** a plurality of actuators are positioned at various points on the surface.

7. The device according to any one of claims 4 to 6, **characterised in that** said actuators consist of piezoelectric actuators.

8. The device according to any one of claims 4 to 7, **characterised in that** said actuators consist of amplified actuators.

**[Fig 1]**

**[Fig 2]**

[Fig 3]

## RÉFÉRENCES CITÉES DANS LA DESCRIPTION

**Documents brevets cités dans la description**

- WO 2008116980 A1
- US 8593409 B1
- US 2016132117 A1
- WO 2018197794 A1